# EUROPEAN PATENT APPLICATION

(11) **EP 0 940 219 A2**
(43) Date of publication of application: **08.09.1999**
(21) Application number: 99102780.6
(22) Date of filing: 23.02.1999
(51) Int. Cl.: B24B 7/17, B24B 7/22, B24B 9/06

(54) **A wafer processing machine and a processing method thereby**

(30) Priority: 05.03.1998 JP 5340898
(71) Applicant: Speedfam Co., Ltd., Kanagawa 252-1123 (JP)
(72) Inventor: Hakomori, Shunji, c/o Speedfam Co., Ltd., Ayase-city, Kanagawa-pref, 252-1123 (JP); Ichikawa, Masahiro, c/o Speedfam Co., Ltd., Ayase-city, Kanagawa-pref, 252-1123 (JP); Amano, Kenji, c/o Speedfam Co., Ltd., Ayase-city, Kanagawa-pref, 252-1123 (JP)
(74) Representative: Kraus, Walter, Dr.

(57) **Abstract**

This invention relates to a sheet feeding type wafer polishing machine which processes both surfaces of wafer and outermost periphery of wafer (edge part) in series, having two platens stuck with a polishing pad or a grinding stone and holding a wafer therebetween. The surface of said wafer is processed by rotating at least one of said two platens and wafer, wherein the diameter of said platens are bigger than the radius of said wafer and smaller than the diameter of said wafer, and said wafer is supported by at least three guide rollers which contact to the outermost periphery of said wafer. Further, the present invention provides an edge polishing and a surface polishing method by said wafer processing machine.

## Description

### BACKGROUND OF THE INVENTION

### FIELD OF THE INVENTION

The present invention relates to a sheet feeding type wafer polishing machine, concretely relates to a sheet feeding type polishing machine which processes both surfaces of wafer and outermost periphery of wafer (edge part) in series. More in detail, relates to a sheet feeding type polishing machine which polishes both surfaces and edge part of a wafer bigger than 12 inches diameter in series, and relates to a processing method by said machine.

### DESCRIPTION OF THE PRIOR ART

An electronic part such as integrated circuit (IC), large-scale integration (LSI) or very large-scale integration (VLSI) are assembled using a small piece of semiconductor device chip on which very fine electric circuit is drawn as a main parts. Said semiconductor device chip is made from a thin wafer which is prepared by slicing a mono-crystalline ingot of silicon or other compound semiconductor. Recently the size of silicon or other compound semiconductor wafer (hereinafter shortened to wafer) is becoming bigger responding to the requirement to improve productivity and productive efficiency. Especially, in a case of silicon wafer, since the manufacturing technique of silicon mono-crystalline ingot which are the starting materials of it is remarkably improved, big size wafers of 12 inch or 16 inch diameter are becoming to be prepared in an industrial scale.

A wafer sliced from an ingot is processed by a lapping process, an etching process and then by a polishing process as to generate a mirror finishing wafer at least one surface is mirror finished. The object of a lapping process is to improve a form accuracy of as cut wafer which has uneven surface after sliced and to form a standard surface and the object of a polishing process is to improve the surface roughness. In general, to perform good productivity and high productive efficiency, a conventional lapping or polishing machine is designed to process plural numbers of wafer at the same time. Concretely, a lapping machine which has big cast iron platens or a polishing machine which has platens with polishing pad on upper and lower part of machine are generally used, and plural numbers of wafer are held by carrier plates. At the actual processing, plural numbers of wafer held by carrier plates are put between upper and lower platen and pressed. The platens and wafer are rotated, while fluid for processing which contains fine particles of abrasive is supplied and wafers are processed. At the final mirror finishing process, usually only one necessary side surface is processed.

Along with the recent growing up of the wafer size, a bigger processing machine which processes plural numbers of bigger size wafer at the same time becomes necessary. However, along with the growing up of size of a processing machine, not only required form accuracy and dimensional stability for the machine becomes more severe but also the handling difficulty for loading and unloading of wafers becomes more troublesome. Therefore, it becomes difficult to expect good productivity and high productive efficiency from bigger size processing machine.

To solve above mentioned specific problem of a bigger size machine, recently a sheet feeding type wafer processing machine which processes a wafer one by one is becoming popular. For example, a double-disc surface grinding machine which uses two diamond grinding wheels is used as a sheet feeding type wafer processing machine. Diamond wheels are rotated by high rotating speed with grinding fluid supply, while wafers are supplied by through feeding system. In this case, since a wafer is processed by grinding mechanism, it is difficult to meet the purpose to obtain a mirror finish surface which can be obtained by polishing.

After fine and complicated electric circuit is engraved on a mirror finished surface of wafer in a device procedure, the wafer is divided to small unit chips. Before dividing process, a wafer is processed maintaining the original circular shape, and among the key processes there are additional procedures such as washing, rinsing, drying and transferring. Trough these procedures, if the shape of outermost periphery of wafer is sharp, sheer and coarse as it is, this portion contacts each other or to the machine and courses fine cracks which generate fine particles, or fine contamination particles are enfold in the coarse surface of edge part. These generated or enfold fine particles are scattered at the latter procedure, contaminate fine processed surface of wafer and affect significantly the yield and the quality of products. In general, to avoid said phenomenon, the sharp outermost periphery of wafer is dulled by a beveling wheel, then the dulled part is mirror finished (edge polishing).

However, if the edge polishing is carried out at the earlier stage, the polished edge surface can be easily damaged and contaminated at the latter procedure, and causes re-contamination which affects significantly the yield and the quality of products. Namely, since the polishing of a wafer surface and an edge surface are carried out independently as a different procedure, these above mentioned problems are coming out.

### BRIEF SUMMARY OF THE INVENTION

The inventors of the present invention, have carried out an intensive study to solve the above mentioned problems, that is, problems which are accompanied with a processing of big size wafer relating to edge polishing, and accomplish the wafer processing machine and a processing method of this invention. The object of this invention is to provide a sheet feeding type wafer polishing machine which processes both surfaces and an outermost periphery of wafer in series. And another object of this invention is to provide a processing method by said polishing machine.

Above mentioned object can be accomplished by a wafer processing machine having two platens stuck with a polishing pad or a grinding stone and holding a wafer therebetween, which processes the surface of wafer by rotating at least one of said two platens and water, wherein the diameter of said platens are bigger than the radius and smaller than the diameter of said wafer, and said wafer is supported by at least three guide rollers which contact to the outermost periphery of said war. Preferably, at least one of said guide roller is a polishing roller. Further, the another object of this invention is accomplished by a wafer polishing method comprising, a wafer whose both surface are lapped and whose outermost periphery is processed by a beveling wheel and etched is set to said processing machine, double faced platens of said processing machine are pressed to the wafer and rotated, drive a polishing roller compulsory by rotating speed so as the periphery speed of groove part is faster than that of outermost periphery of wafer to polish the outermost periphery of wafer, then stop the compulsory drive of the roller, increase the rotating speed of said double faced platens and polish the both surface of the wafer.

In the polishing machine of this invention, the polishing roller can be a compulsory driving roller or a free rotating roller as needed. Further, the kind polishing pad is not limited, however, it is desirable to use synthetic resin foam, non woven cloth, resin treated non woven cloth, synthetic leather or a composite product of them. Still further, referring to the grinding stone, it is not intended to be limited, but it is desirable to use a soft type synthetic grinding stone in which abrasives are fixed by low bondage resin. Furthermore, two platens of said polishing machine of this invention can be placed horizontally or vertically.

### BRIEF DESCRIPTION OF THE SEVERAL VIEWS OF THE DRAWINGS

FIG. 1 is the side view of the wafer processing machine of this invention
FIG. 2 is the plan view of the wafer processing machine of this invention.
FIG. 3 is the side view of another example of the wafer processing machine of this invention.

In the drawings, each numerical number indicates,
- 1 :: wafer,
- 2 :: upper platen,
- 3 :: lower platen,
- 4 :: polishing pad,
- 5, 5' :: guide roller,
- 6 :: polishing roller,
- 6' :: groove of polishing roller,
- 7 :: compound supplying hole (upper platen),
- 8 :: compound supplying hole (lower platen),
- 9 :: tank

### DETAIL DESCRIPTION OF THE INVENTION

The present invention will be illustrated more in detail using attached drawings, however, it is not intended to be limited to them.

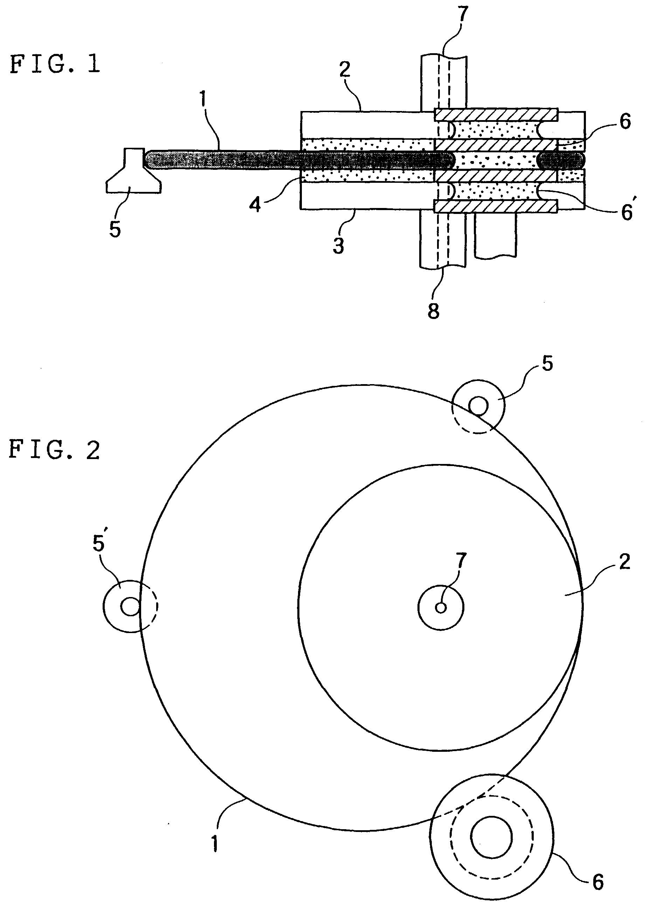

FIG. 1 is a side view of one example of wafer processing machine of this invention, and FIG. 2 is a plan view of it. This Example shows the type of machine in which the double faced platens are arranged horizontally. The outermost periphery of a wafer 1 is supported by guide roller 5, 5' and a polishing roller 6. The surface of wafer is held between an upper platen 2 and a lower platen 3 whose surfaces are stuck with polishing pad 4. To the groove part 6' of polishing roller 6, same materials as said polishing pad is stuck. Slurry for processing which contains abrasives for processing is supplied to the surface of machine through the supplying holes 7 and 8 dug through the center of upper and lower platen. The upper platen 2 and lower platen 3 are independently driven by an individual driving motor (not indicated in the drawing), and also the polishing roller 6 is independently driven by an individually established driving motor (not indicated in the drawing). Since the guide rollers 5, 5' and the polishing roller 6 are established to support the outermost periphery of the wafer and to maintain the dimensional stability of the wafer, these rollers have a function to hold the wafer by adequate pressure and the holding pressure can be controlled as needed.

The wafer 1 is rotated accompanied with the rotation of upper platen 2 and lower platen 3,and the rotation can be controlled by regulating the holding pressure of said guide rollers 5, 5' and the polishing roller 6. Since the wafer 1 rotates accompanied with the rotation of platens, the position of wafer 1 which faces to the upper and lower platens 2, 3 traverses gradually. In this invention, the diameter of the upper and lower platens 2, 3 is bigger than the radius of the wafer 1. Therefore, although the surface area of each platen is smaller than that of wafer 1, the platen can cover the whole surface of the wafer at the processing, and can avoid a problem that the unprocessed portion remains or a problem of uneven processing. If the diameter of platens are not bigger than the radius of wafer, the platens can not cover the whole surface of water, and a problem of uneven processed surface raises which is caused by the difference of periphery speed of the outer periphery part and the of center part of platens. Further, if the diameter of platens is bigger than that of the diameter of wafer, the construction of the machine becomes different from that of this invention.

In the example shown in FIG. 1 and FIG. 2, compound for processing is supplied through the supplying holes 7 and 8 dug through the center of upper and lower platen and spread to whole surface of wafer homogeneously by centrifugal force accompanied with the rotation of platens, and it is desirable to form the grooves of radial or spiral shape on the surface of a polishing pad or a grinding stone to make the spreading of the compond more smooth.

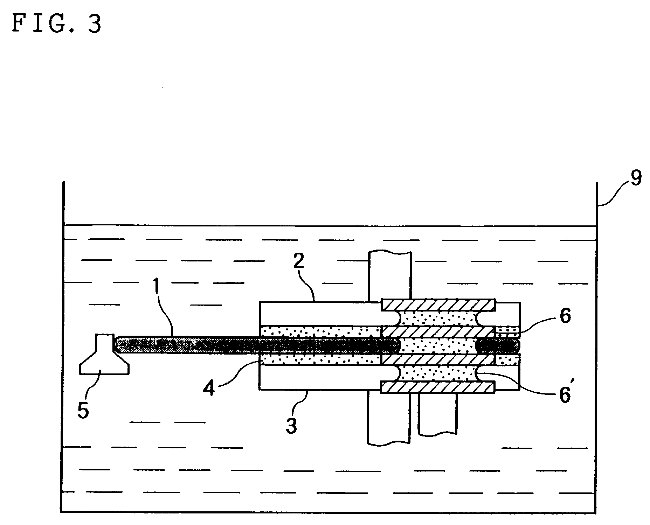

FIG. 3 is a drawing which shows another Example of this invention, and main parts of this machine is dipped into a tank 9. In the tank 9, compound necessary for processing, for instance, slurry type compound containing colloidal silica is filled up. In this case, since all procedure for processing is carried out in this tank, it is not necessary to provide a supplying hole through platen. Further, in this case, compound exists homogeneously on whole surface of wafer.

The method for processing of wafer by the wafer processing machine of this invention is illustrated with reference to FIG. 1 and FIG. 2.

To the surface of upper and lower platen 2, 3 and to the surface of groove 6' of the polishing roller 6, same kind of polishing pad is stuck. Both surface of a wafer is lapped, outermost periphery is ground by a beveling wheel, then the wafer is etched by an etching process. The etched wafer 1 is provided as a specimen and set to the machine indicated by FIG. 2 and 3. The wafer 1 is supported by two guide roller 5, 5' and a polishing roller 6, double faced upper and lower platens are pressed to the surface of wafer 1 and rotated. The wafer 1 is rotated accompanied with the rotation of platens. Rotate the polishing roller 6 compulsory so as the periphery speed of groove 6' part faster than that of rotating speed of outermost periphery of wafer with constant or intermediate supply of compound for processing and polish the outermost periphery of wafer. After the polishing of outermost periphery of water, the compulsory rotation of polishing roller 6 is stopped and make the polishing roller 6 a free rotating roller, then the pressure of guide roller is reduced. Increase the rotating speed of upper and lower platen, supply the compound for processing through the supplying holes 7 and 8, and polish the both surface of wafer. The desirable pressure for polishing is from 100 to 500g/cm², and the desirable rotating speed of platens is from 100 to 1000 rpm.

The present invention will be understood more readily with reference to the Example, however the Example is intended to illustrate the invention and not be construed to limit the scope of the invention.

### Example

SUBA 400 (product of Rodel·Nitta) whose thickness is 1.27mm is used as the polishing pad, and is stuck to the surface of upper and lower platen and to the surface of groove surface of the polishing roller. In this case, the diameter of upper and lower platen is 170mm. Weak alkaline slurry type compound mainly composed by colloidal silica is supplied as polishing compound and an etched wafer of 300mm diameter is polished by this machine. The polishing pressure is 100 g/cm² and the rotating speed of platens is 600rpm. The whole surface and outermost periphery of the wafer are perfectly polished, and the defects such as uneven surface, scars or scratches are not observed on the polished surface. Surface roughness Ra after polished is 3∼5Å.

As illustrated above, in the field of precision processing of semi conductor materials such as silicon wafer, it becomes possible to process both surface of wafer and outermost periphery of wafer in series by the sheet feeding type wafer processing machine of this invention. Further, by this machine, it becomes possible to dissolve the problem of troublesome handling accompanied with the processing of large size wafer, and additionally, the processing machine becomes lighter and more compact. By this machine, the connection of processing machines in series with other processing machine is more easy compared with other conventional type machine. Thus the effect of this machine is obvious.

## Claims

1. A wafer processing machine having two platens stuck with a polishing pad or a grinding stone and holding a wafer therebetween, which processes the surface of said wafer by rotating at least one of said two platens and wafer, wherein. the diameter of said plains are bigger than the radius of said wafer and smaller than the diameter of said wafer, and said wafer is supported by at least three guide rollers which contact to the outermost periphery of said wafer.

2. The wafer processing machine of claim 1, wherein at least one of guide roller is a polishing roller.

3. The wafer processing machine of claim 2, wherein the polishing roller is a compulsory driving roller.

4. The wafer processing machine of claims 1, wherein the polishing pad is at least one selected from the group composed by synthetic resin foam, non woven cloth, resin treated non woven cloth, synthetic leather or a composite product of them.

5. The wafer processing machine of claims 1, wherein the grinding stone is a synthetic grinding stone in which colloidal silica is fixed by as abrasives.

6. A wafer processing method comprising, setting a wafer whose both surface are lapped and whose outermost periphery is processed by a beveling wheel and then etched, to said processing machine, pressing double faced platens of said processing machine to the wafer and rotating, driving a polishing roller compulsory by rotating speed so as the periphery speed of groove part is faster than that of outermost periphery of wafer to polish the outermost periphery of water, then stopping the compulsory drive of the roller, increasing the rotating speed of said double faced platens and polishing the both surface of wafer.
